(19) Europäisches Patentamt
European Patent Office
Office européen des brevets

(11) Veröffentlichungsnummer: **0 249 744**
**B1**

(12) # EUROPÄISCHE PATENTSCHRIFT

(45) Veröffentlichungstag der Patentschrift: **11.10.89**

(51) Int. Cl.[4]: **B 05 D 1/00**, H 05 K 3/02

(21) Anmeldenummer: **87106980.3**

(22) Anmeldetag: **14.05.87**

(54) **Verfahren zur Herstellung von Polyimid-Metall-Laminaten.**

(30) Priorität: **19.06.86 DE 3620601**

(43) Veröffentlichungstag der Anmeldung: **23.12.87 Patentblatt 87/52**

(45) Bekanntmachung des Hinweises auf die Patenterteilung: **11.10.89 Patentblatt 89/41**

(84) Benannte Vertragsstaaten: **AT BE CH DE ES FR GB IT LI LU NL SE**

(56) Entgegenhaltungen:
**US-A- 4 568 413**
**US-A- 4 650 545**
**US-E- 29 820**

(73) Patentinhaber: **AKZO N.V.**
**Velperweg 76**
**NL-6824 BM Arnhem (NL)**

(72) Erfinder: **Benz, Volker, Dr.**
**Am Dachsrain 13**
**D-6128 Höchst 2 (DE)**
Erfinder: **Kundinger, Ernst F., Dr.**
**Odenwaldring 28**
**D-6127 Breuberg /Neustadt (DE)**

(74) Vertreter: **Fett, Günter**
**Akzo Patente GmbH Kasinostrasse 19 - 23**
**D-5600 Wuppertal 1 (DE)**

**EP 0 249 744 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zur Herstellung von Laminaten aus mindestens einer Schicht aus einem Metall M 1 und mindestens einer direkt damit verbundenen Schicht aus Polyimid durch Aufbringen einer Schicht einer Lösung eines Polyimids oder einer Lösung einer in ein Polyimid umwandelbaren Polyamidsäure auf einen Träger und Umwandlung der Lösung in festes Polyimid.

Laminate, welche Schichten aus Polyimid und Metall enthalten, lassen sich vielseitig verwenden, so z. B. für gedruckte elektrische Schaltkreise. Hierbei wird von den hervorragenden Eigenschaften wie thermischer Beständigkeit und elektrischem Isoliervermögen der Polyimide Gebrauch gemacht. Polyimid-Metall-Laminate und verschiedene Verfahren zu ihrer Herstellung sind bekannt. Die Polyimide, welche in diesen Laminaten enthalten sind, lassen sich mittels der seit langem bekannten Umsetzung von Tetracarbonsäuren oder deren Dianhydriden mit Diaminen erhalten. Hierbei entstehen über die Zwischenstufe der entsprechenden Polyamidsäuren durch eine Hitzebehandlung die Polyimide. Diese Umsetzung ist beispielsweise in der US-PS 3, 179, 614 beschrieben.

Zur Herstellung von Laminaten, welche Schichten aus Polyimiden und Metallen enthalten, wurden verschiedene Verfahren bereits vorgeschlagen. So beschreibt die DE-OS 20 63 506 ein Verfahren, mittels dessen ein anorganischer Werkstoff mit einem Polyimid über eine dazwischenliegende Schicht aus Polyimid unter Anwendung von Hitze und Druck verbunden werden kann. Der Nachteil dieses Verfahrens besteht darin, daß die Zwischenschicht, die auf das anorganische Material zu liegen kommt, aus einem heißsiegelbaren Polyimid bestehen muß. Es ist jedoch für bestimmte Anwendungsgebiete erforderlich, daß die am anorganischen Material, z. B. Metall, haftende Polyimidschicht aus einem nicht-heißsiegelbaren Polyimid besteht, da diese Polyimide den heißsiegelbaren bezüglich ihrer thermischen Beständigkeit überlegen sind. Laminate, welche nur Metall und nicht-heißsiegelbares Polyimid, auch als nicht mehr formbares Polyimid bezeichnet, enthalten, lassen sich nach dem Verfahren dieser DE-OS nicht herstellen.

Ein ähnliches Verfahren wird in der GB-PS 21 01 526 beschrieben. Bei diesem Verfahren werden ebenfalls eine Metall- und eine Polyimidschicht miteinander unter Druck- und Hitzeeinwirkung verbunden. Die Polyimidschicht besteht hierbei gezwungenermaßen wie die Zwischenschicht im Fall der DE-OS 20 63 506 aus einem heißsiegelbaren Polyimid. Dieses Verfahren weist also ebenfalls den Nachteil auf, daß es nicht möglich ist, damit Laminate aus Metall und einem direkt damit verbundenen nicht-heißsiegelbaren Polyimid herzustellen. Wegen der Nachteile der geschilderten Verfahren wurden Verfahren vorgeschlagen, bei denen eine Schicht aus einem nicht-heißsiegelbaren, also nicht mehr formbaren, Polyimid direkt an einem metallischen Trägermaterial ohne verbindende Zwischenschicht haftet. So beschreibt die den Oberbegriff des Anspruchs 1 bildende DE-OS 33 01 197 ein Verfahren zur Herstellung von Polyimid-Laminaten, bei dem das nicht mehr formbare Polyimid auf einem Trägermaterial durch chemische Reaktion gebildet wird. Nach diesem Verfahren lassen sich Metall-Polyimid-Laminate mit guten thermischen und elektrischen Eigenschaften herstellen.

Ein gemeinsamer Nachteil aller hier vorgestellter Verfahren besteht darin, daß man Trägermaterialien mit einer bestimmten Mindestschichtdicke verwenden muß. Um das Trägermaterial, das im Normalfall ein Metall ist, gut handhaben und mit Polyimid bzw. dessen Vorstufe mittels hierzu vorgesehener Apparaturen beschichten zu können, ist die Schichtdicke des Metalls nach unten limitiert.

Die Folge ist, daß es schwierig oder gar unmöglich wird, nach diesen Verfahren Polyimid-Metall-Laminate mit sehr dünnen Metallschichten herzustellen. Laminate mit sehr niedrigen Schichtdicken an Metall sowie ggf. auch an Polyimid weisen jedoch bei bestimmten Einsatzgebieten Vorteile gegenüber Laminaten mit dickeren Metallschichten auf, so z. B. bei Einsatz in Kondensatoren.

Es ist zwar prinzipiell denkbar, Laminate aus metallischen Schichten und Polyimidschichten mit dünnen Schichtdicken an Metall dadurch herzustellen, daß man nach den oben genannten Verfahren zuerst Laminate mit dickeren Metallschichten herstellt und anschließend durch chemisches Abätzen eines Teils der Metallschicht zu dünneren Metallschichten gelangt. Ein solches Verfahren ist jedoch mit Nachteilen behaftet. Zum einen ist es schwierig, das Abätzen so vorzunehmen, daß gleichmäßige Schichtdicken und glatte Metalloberflächen entstehen, zum anderen ist die Wiedergewinnung des abgeätzten Metalls aufwendig und kann zu Umweltproblemen führen.

Im Prinzip ist es auch möglich, Laminate mit dünnen Metallschichten und Polyimidschichten dadurch herzustellen, daß man auf einer Polyimidschicht eine dünne Metallschicht, z. B. durch Aufdampfen, erzeugt. Nachteil dieses Verfahrens ist jedoch, daß, wegen der schlechten Handhabbarkeit dünner Schichten, die Polyimidschicht hierbei eine gewisse Mindestdicke besitzen muß. Mit anderen Worten, es ist auch nach diesem Verfahren nicht oder nur mit Schwierigkeiten möglich, Laminate herzustellen, bei denen sowohl die Metallschicht als auch die damit verbundene Polyimidschicht sehr dünn ist. Daneben können bei nach diesem Verfahren hergestellten Laminaten Probleme bezüglich schlechter Haftung zwischen Metall und Polyimid auftreten, vor allem dann, wenn ein nicht formbares bzw. duromeres ausgehärtetes Polyimid verwendet werden soll.

Dem erfindungsgemäßen Verfahren lag somit die Aufgabe zugrunde, ein verbessertes Verfahren zur Verfügung zu stellen, mit dem Polyimid-Metall-Laminate mit sehr niedrigen Schichtdicken an Metall und an Polyimid und damit auch sehr niedrigen Gesamtschichtdicken und guter Haftung zwischen Polyimid und Metall hergestellt werden können. Eine weitere Anforderung an das Verfahren bestand darin, daß es

sowohl die Herstellung von Laminaten aus Metall und heißsiegelbarem Polyimid als auch die von Laminaten aus Metall und nicht-heißsiegelbarem, d. h. nicht mehr formbarem, Polyimid ermöglichen sollte.

Die Aufgabe wurde gelöst durch ein Verfahren gemäß Oberbegriff von Anspruch 1, das dadurch gekennzeichnet ist, daß man einen Träger verwendet, der aus einer Schicht aus einem Metall M 1 und einer damit verbundenen Schicht aus einem von M 1 verschiedenen Material M 2 besteht, wobei das Material M 2 mindestens eine glatte Oberfläche aufweist, auf der sich eine Schicht aus Metall M 1 befindet, die durch Bedampfen, Bedrucken, Aufrakeln oder Aufsprühen des Metalls M 1 in elementarer Form auf diese Oberfläche erzeugt worden ist, daß man die Lösung des Polyimids oder der Polyamidsäure auf die freiliegende Oberfläche der Schicht aus Metall M 1 aufbringt und daß man nach der Umwandlung der Lösung in festes Polyimid die Schicht aus Material M 2 entfernt.

Durch dieses Verfahren ist es möglich, Laminate herzustellen, in denen eine Schicht aus einem Metall M 1 direkt mit einer Schicht aus einem Polyimid ohne verklebende Zwischenschicht verbunden ist. Vorteile des Verfahrens gegenüber bekannten Verfahren liegen darin, daß damit Laminate herstellbar sind, die eine Schicht aus einem nicht mehr formbaren Polyimid enthalten, die direkt mit der Metallschicht verbunden ist, und daß es möglich ist, Laminate herzustellen, in denen sowohl die Schicht aus Metall M 1 als auch die Schicht aus Polyimid sehr dünn ist. Damit können die mit dem erfindungsgemäßen Verfahren herstellbaren Laminate sehr niedrige Gesamtschichtdicken aufweisen, was für bestimmte Einsatzzwecke wie gewickelte oder gestapelte Dünnfilmkondensatoren, Folienkondensatoren, Leiterbahnstrukturen etc. von Vorteil ist. Durch die Maßnahme, bei dem erfindungsgemäßen Verfahren ein zweites Material M 2 zu verwenden, das nach der Ausbildung des festen Polyimids entfernt wird, gelingt es, Laminate geringer Gesamtschichtdicke herzustellen, bei denen die Dicke der Schicht aus Metall M 1 nur etwa 0,05 µm beträgt. Dies ist nach bekannten Verfahren entweder nicht möglich oder nur unter Schwierigkeiten, wobei wegen der schlechten Handhabbarkeit von Körpern mit niedriger Schichtdicke Nachteile in Kauf genommen werden müssen. Es ist für das erfindungsgemäße Verfahren wesentlich, daß nach der Ausbildung der Schicht aus festem Polyimid das Material M 2 entfernt werden kann. Da das Material M 2, auf das eine Schicht aus Metall M 1 durch Bedampfen, Bedrucken, Aufrakeln oder Aufsprühen aufgebracht worden ist, mit der Schicht aus Metall M 1 verbunden ist, muß die Entfernung von M 2 über eine Trennung von M 1 und M 2 erfolgen. Damit dies ohne Schwierigkeiten möglich ist, wird als Material M 2 nicht das gleiche Material verwendet wie für die Schicht aus Metall M 1. Die Maßnahme, die Schicht aus Metall M 1 durch Bedampfen, Bedrucken, Aufrakeln oder Aufsprühen auf das Material M 2 aufzubringen, dient ebenfalls dem Zweck, die spätere Trennung von M 1 und M 2 ohne Schwierigkeiten durchführen zu können. Damit nach der Entfernung des Materials M 2 ein Laminat, bestehend aus einer Schicht aus Metall M 1 und einer damit verbundenen Polyimidschicht erhalten wird, muß das Material M 2 mindestens eine glatte Oberfläche aufweisen. Diese glatte Oberfläche kann eine ebene Oberfläche sein oder eine dreidimensional verformte ebene Oberfläche, z. B. eine zu einer dreidimensionalen Wellenform oder Zickzackform verformte ebene Oberfläche. Die Zickzack- oder Wellenform führt hierbei zu Laminaten, welche ebenfalls Zickzack- oder Wellenform aufweisen und in Längs- und/oder Querrichtung verdehnbar sein können. Auf diese glatte Oberfläche wird M 1 aufgebracht. Wenn diese Oberfläche aus Metall besteht, ist es erforderlich, daß die Schicht aus Metall M 1 diese Oberfläche vollständig bedeckt, so daß keine « Inseln » auf dieser Oberfläche verbleiben, die aus Material M 2 bestehen. Dies ist nötig, damit keine direkte Verbindung zwischen aus M 2 stammendem Material und Polyimid entsteht, da sonst an diesen Stellen die Entfernung des Materials M 2 wegen hoher Haftung am Polyimid schwierig oder unmöglich werden kann und da, selbst wenn die vollständige Entfernung von M 2 gelänge, in den Laminaten Fehlstellen auftreten würden, hervorgerufen durch « Inseln » aus Polyimid an der Oberfläche der Schicht aus Metall M 1. Es ist jedoch, wie unten näher erläutert, möglich, daß die glatte Oberfläche von M 2, auf die M 1 aufgebracht wird, nicht aus Metall besteht, sondern aus einem Material, das schlecht an Polyimid haftet, wie z. B. aus Oxiden des Siliciums oder Metallsilikaten. In diesem Fall muß M 1 nicht notwendigerweise die gesamte Oberfläche von M 2 bedecken, sondern es können Inseln aus Material M 2 verbleiben, sofern die hierdurch in den Metall M 1/Polyimid-Laminaten hervorgerufenen Inseln aus Polyimid in der Metall (M 1)-Oberfläche sich nicht störend auf den vorgesehenen Einsatzzweck auswirken.

Das Bedampfen, Bedrucken, Aufrakeln oder Aufsprühen der Schicht aus Metall M 1 auf Material M 2 kann nach an sich bekannten Methoden erfolgen. Geeignete Methoden sind beispielsweise in « Handbook of Thin Film Technology » von L.I. Maissel und R. Glang, Mc Graw Hill 1970, sowie in « Metallic Coating of Plastics », Vol. 1 von W. Goldie, Electrochemical Publication 1968, Hatch End, beschrieben. Bei allen genannten Applikationsmethoden wird das Metall M 1 in elementarer Form eingesetzt. Das Aufrakeln ist beispielsweise möglich durch Aufrakeln einer Dispersion des Metalls M 1 und anschließender Entfernung des Dispergiermittels, was beispielsweise durch dessen Verdampfung erfolgen kann. Es ist in manchen Fällen möglich, die glatte Oberfläche des Materials M 2, auf die die Schicht aus Metall M 1 aufgebracht werden soll, vorher durch Glimmen in einem Inertgasplasma oder Sauerstoffplasma vorzubehandeln. Diese Maßnahme kann dazu dienen, die Haftung der Schicht des Metalls M 1 am Material M 2 zu erniedrigen und so die spätere Entfernung des Materials M 2 zu erleichtern. Als vorteilhaftes Medium für dieses Glimmen läßt sich Argon verwenden. Diese Vorbehandlung durch Glimmen kann nach bekannten Methoden erfolgen, z. B. nach dem in « Veredeln von Kunststoffoberflächen », H. Walter : « Vakuummetallisieren von Kunststoffolien », Seite 107 ff, Hanser Verlag 1974, angegebenen Verfahren oder nach Verfahren, wie sie in gängigen Lehrbüchern beschrieben sind oder nach Verfahren, wie sie in den o. a. Publikationen beschrieben sind, die sich mit der Applikation der Metallschicht beschäftigen.

Das Material M 2 kann aus Kunststoff bestehen, z. B. aus Polyimid. In letzterem Fall ist es nötig, daß das Metall M 1 die Oberfläche von M 2, auf die es aufgebracht wird, vollständig bedeckt. Andernfalls würde es nämlich zu einer direkten Verbindung zwischen der Polyimidoberfläche von M 2 und der Polyimidschicht kommen, die auf der anderen Oberfläche von M 1 erzeugt wird, also zu einer direkten Verbindung zweier Polyimidschichten, wodurch die vollständige Entfernung von M 2 schwierig oder unmöglich werden kann. Verwendet man jedoch für M 2 ein Kunststoffmaterial, das an Polyimid schlecht haftet, muß M 1 die Oberfläche von M 2 nur dann vollständig bedecken, wenn in den fertigen Laminaten nach vollständiger Entfernung von M 2 verbleibende Inseln aus Polyimid in der Oberfläche von M 1 sich für den Einsatzzweck störend auswirken würden. Vielfach ist es sogar von Vorteil, wenn das Metall M 1 die Kunststoff-Oberfläche von Material M 2 nur teilweise bedeckt. Auf diese Weise läßt sich in den fertigen, aus Polyimid und Metall M 1 bestehenden, Laminaten direkt eine Strukturierung, z. B. in Form von Leiterbahnen erzeugen ; dies kann durch Aufbringen des Metalls M 1 durch eine Maske hindurch erfolgen, wobei diese Maske das Negativ der gewünschten Leiterbahnstruktur darstellt.

In einer bevorzugten Ausführungsform des Verfahrens wird ein metallisches Material als Material M 2 eingesetzt. Metall M 1 und gegebenenfalls M 2 müssen nicht elementare Metalle sein, es können für M 1 und/oder M 2 auch Legierungen eingesetzt werden.

Auch muß das Material M 2 nicht aus einem einheitlichen Material bestehen, sondern gegebenenfalls kann M 2 ein Körper aus mehreren Schichten, z. B. aus verschiedenen Metallen, sein. In diesem Fall muß jedoch mindestens diejenige Oberfläche von M 2, auf die die Schicht aus Metall M 1 aufgebracht wird, aus einem anderen Material bestehen als M 1.

In einer vorteilhaften Ausführungsform des erfindungsgemäßen Verfahrens verwendet man als Material M 2 ein Laminat aus einer Metallschicht und einer darauf aufgebrachten Schicht aus einem Oxid des Siliciums oder aus einem Metallsilikat. Das Oxid des Siliciums kann hierbei $SiO_2$ oder SiO oder $SiO_x$ sein, wobei x einen Wert zwischen 1 und 2 besitzt. Im letzteren Fall handelt es sich um ein nicht stöchiometrisch zusammengesetztes Oxid des Siliciums. Es hat sich gezeigt, daß diese siliciumhaltigen Schichten schlechte Haftung zu Polyimid aufweisen. Es ist daher möglich, auf diese siliciumhaltige Oberfläche von M 2 die Schicht aus Metall M 1 nicht in geschlossener Form, sondern in strukturierter Form aufzubringen, z. B. in Form einer Leiterbahnstruktur mittels eines Siebdruckverfahrens. Wegen der schlechten Haftung der Si-haltigen Oberfläche von M 2 an Polyimid kann nach Umwandlung der auf M 1 aufgebrachten Lösung in Polyimid das Material M 2 trotz direkter Verbindung zu Polyimid vollständig entfernt werden. Es sind somit Laminate nach diesem Verfahren herstellbar, bei denen sich auf einem zusammenhängenden Polyimidfilm eine Leiterbahnstruktur niedriger Schichtdicke aus Metall M 1 befindet. Diese Laminate können dann zu Mehrfachlaminaten, sogenannten double clads oder Multiclads weiterverarbeitet werden.

Als besonders geeignet für Material M 2 haben sich Kupfer, Nickel, Aluminium oder Edelstahl erwiesen. Auch Materialien, die Silicium enthalten, wie reines Silicium, Siliciumdioxid oder technische Materialen wie Keramik oder Glas sind gut geeignet.

Für Metall M 1 haben sich Nickel, Kupfer, Aluminium, Chrom, Gold, Silber oder Palladium als vorteilhaft erwiesen.

Obwohl das Material M 2 prinzipiell in beliebiger räumlicher Form z. B. in Form einer starren oder flexiblen Platte eingesetzt werden kann, sofern nur mindestens eine glatte Oberfläche vorhanden ist, auf die das Metall M 1 aufgebracht wird, ist es vorteilhaft, wenn man das Material M 2 in Form einer Folie verwendet. Man erhält so nach dem Aufbringen von M 1 einen Träger, der ebenfalls die Form einer Folie besitzt und auf den die Lösung eines Polyimids oder eine Polyamidsäurelösung ohne Schwierigkeiten aufgebracht werden kann. Durch die Verwendung einer Folie aus Material M 2 und somit auch einer Folie als Träger läßt sich die Herstellung der Laminate kontinuierlich durchführen, z. B. indem man eine Trägerfolie kontinuierlich zuliefert, mit der Lösung aus Polyimid oder Polyamidsäure beschichtet und kontinuierlich durch eine oder mehrere Heizzonen führt, wo die Umwandlung in festes Polyimid erfolgt. Die kontinuierliche Durchführung des erfindungsgemäßen Verfahrens, d. h. kontinuierliches Aufbringen der Lösung auf einen kontinuierlich ablaufenden Träger stellt eine bevorzugte Ausführungsform dar.

Verwendet man das Material M 2 in Form einer Folie, so ist es vorteilhaft, wenn diese Folie eine Zugfestigkeit aufweist, die mindestens um 20 % höher liegt als die Schälfestigkeit, mit der die Schicht aus Metall M 1 am Material M 2 haftet. Auf diese Weise läßt sich die spätere Entfernung der Folie M 2 durch mechanisches Abziehen bewerkstelligen, ohne daß die Folie hierbei reißt. Die Einstellung dieser um mindestens 20 % höheren Zugfestigkeit läßt sich bequem über die Dicke der Folie erreichen. Die Messung der Schälfestigkeit, mit der die Schicht aus Metall M 1 am Material M 2 haftet, kann nach der in IPC TM 650, 2.4.9 angegebenen Methode erfolgen.

Unabhängig davon, in welcher räumlichen Form das Material M 2 eingesetzt wird, ist es von Vorteil, wenn die Schälfestigkeit, mit der die Schicht aus Metall M 1 am Material M 2 haftet, kleiner ist als etwa 2 N/cm ; vorzugsweise sollte sie sogar niedriger als 0,5 N/cm sein. Bei niedrigen Schälfestigkeiten läßt sich nämlich das Material M 2 bequem durch mechanisches Abziehen als Ganzes von der Schicht aus Metall M

1 entfernen. Bei geeigneter Auswahl von M 1 und M 2 kann die Schälfestigkeit so niedrig sein, daß bereits während der Umwandlung der Lösung in festes Polyimid von selbst eine teilweise oder sogar nahezu vollständige Trennung des Metalls M 1 vom Material M 2 stattfindet. Eine bevorzugte Ausführungsform des erfindungsgemäßen Verfahrens besteht darin, das Entfernen von Material M 2 mechanisch durchzuführen, wobei M 2 als Ganzes entfernt wird. Entfernen « als Ganzes » bedeutet in diesem Zusammenhang, daß M 2 ohne Brüche in seiner kompakten räumlichen Form entfernt wird. Diese mechanische Entfernung als Ganzes wird durch die angegebenen niedrigen Schälfestigkeiten sehr erleichtert. Den angegebenen Werten für die Schälfestigkeit liegt die oben bereits angeführte Meßmethode zugrunde.

Außer der mechanischen Entfernung als Ganzes kann zwar das Material M 2 auch nach anderen Methoden entfernt werden, wie z. B. durch chemisches Abätzen. Chemisches Abätzen ist jedoch weniger günstig als die mechanische Entfernung, da einerseits die Rückgewinnung des Materials M 2 in diesem Fall aufwendiger ist, was besonders zum Tragen kommt, wenn für M 2 ein Metall verwendet wird, und andererseits im Normalfall vermieden werden muß, daß die Oberfläche an Metall M 1 beim Abätzen angegriffen wird. Daher sollte diese Variante auf wenige spezielle Einzelfälle beschränkt bleiben. Sie kann z. B. angewandt werden, wenn für Metall M 1 Chrom und für M 2 Kupfer verwendet wird, da ein Abätzen von Cu möglich ist, ohne daß Cr angegriffen wird.

Wie bereits erwähnt, liegt ein wesentlicher Vorteil des erfindungsgemäßen Verfahrens darin, daß es möglich ist, Laminate mit sehr niedrigen Schichtdicken an Metall (M 1) und an Polyimid und somit niedrigen Gesamtschichtdicken herzustellen. Dies wird ermöglicht durch die Verwendung eines Trägers bestehend aus Material M 2 und Metall M 1, so daß es nicht erforderlich ist, aus Gründen der Handhabbarkeit größere Schichtdicken an Metall M 1 einzustellen. Die Handhabbarkeit des Trägers wird vielmehr über die Dicke des Materials M 2 erzielt, die nahezu beliebig sein kann. Da Laminate mit niedrigen Schichtdicken an Metall (M 1) häufig anwendungstechnische Vorteile bieten, besteht eine bevorzugte Ausführungsform des erfindungsgemäßen Verfahrens darin, daß man einen Träger verwendet, bei dem Dicke der Schicht aus Metall M 1 zwischen 0,05 µm und 4 µm liegt. Die Einstellung dieser Schichtdicke erfolgt durch die beim Bedampfen, Bedrucken, Aufrakeln oder Aufsprühen aufgebrachte Menge an Metall M 1. Die Schichtdicken an Metall können mit der bekannten Schwingquarzmethode bestimmt werden. Die in den Ausführungsbeispielen genannten Schichtdicken an Metall beziehen sich auf diese Methode. Die Methode ist beschrieben in « Handbook of Thin Film Technology », L.I. Maissel, R. Glang, Mc Graw Hill, U.S.A., 1970, Chapt. 1.

In einer weiter bevorzugten Ausführungsform des Verfahrens beträgt die Schichtdicke an Metall M 1 0,1 bis 2 µm.

Die Dicke der Polyimidschicht kann bei den Laminaten, die nach dem erfindungsgemäßen Verfahren hergestellt werden, ebenfalls gering sein. Obwohl für manche Einsatzgebiete der Laminate dickere Schichten aus Polyimiden in Frage kommen können, ist es in einer Reihe von Fällen erstrebenswert, die Dicke der Polyimidschicht auf einen Wert im Bereich von etwa 2 µm bis 75 µm einzustellen.

Die ist mit dem erfindungsgemäßen Verfahren möglich. Eine vorteilhafte Ausführungsform des Verfahrens besteht somit darin, daß man die Lösung des Polyimids oder der Polyamidsäure auf den Träger in einer Schichtdicke von 2 µm · x bis 75 µm · x aufbringt, wobei x der Quotient aus der Schichtdicke einer bestimmten Menge dieser Lösung und der Schichtdicke des aus dieser Menge zu erhaltenden festen Polyimids ist.

Nach der Umwandlung der Lösung in festes Polyimid erhält man in diesem Fall eine Polyimidschichtdicke zwischen 2 µm und 75 µm.

Die Schichtdicken der Polyimide lassen sich im Fall niedriger Werte, d. h. bis zu etwa 4 µm, durch Elektronenmikroskopie von Schnitten bestimmen. Im Fall von Schichtdicken von mehr als etwa 4 µm kann die Bestimmung mechanisch mit Mikrometerschraube oder durch eine Wirbelstrommethode, z. B. mit einem Gerät Elcometer 256 FN der Fa. Electrometer Instruments Ltd., Manchester, UK erfolgen. Den in den Ausführungsbeispielen genannten Werten für die Schichtdicke an Polyimid liegen diese Methoden zugrunde.

Die nach dem erfindungsgemäßen Verfahren herstellbaren Laminate enthalten neben mindestens einer Schicht aus einem Metall (M 1) mindestens eine direkt mit der Metallschicht verbundene Schicht aus Polyimid. Polyimide sind polymere Verbindungen, welche sich unter anderem durch Reaktion von Tetracarbonsäuren mit Aminen erhalten lassen. Diese Amine müssen hierzu mindestens zwei primäre Aminogruppen im Molekül aufweisen. Anstelle von Tetracarbonsäuren können auch Dianhydride oder Ester oder Teilester von Tetracarbonsäuren eingesetzt werden. Viele dieser Umsetzungen verlaufen über die Zwischenstufe der Polyamidsäuren, die durch eine Hitzebehandlung unter Wasserabspaltung in Polyimide überführt werden können. Polyimide enthalten somit die Struktureinheit

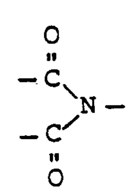

mehrfach im Molekül. Die vier Carboxylgruppen bzw. die zwei Dianhydridgruppen oder Estergruppen der Tetracarbonsäuren bzw. Dianhydride oder Ester die als Ausgangsmaterial verwendbar sind, können sich auch als Substituenten an gesättigten, ein- oder mehrfach ungesättigten sowie aromatischen, carbocyclischen oder heterocyclischen Ringen befinden. Die Amine können unter anderem aliphatische oder aromatische diprimäre Diamine sein. Es ist auch möglich, daß die beiden primären Aminogruppen der Diamine sich an zwei verschiedenen aromatischen, cycloaliphatischen, cycloolefinischen oder heterocyclischen Ringen befinden. Diese Ringe können direkt oder über brückenbildende Atome bzw. zweiwertige Reste miteinander verbunden sein.

Es ist möglich, mit dem erfindungsgemäßen Verfahren Laminate herzustellen, bei denen das Polyimid ein heißsiegelbares, d. h. unter Einwirkung von Hitze und gegebenenfalls zusätzlich von Druck formbares, Polyimid ist. Unter heißsiegelbaren Polyimiden werden dabei Polyimide verstanden, welche bei einer Temperatur im Bereich zwischen 150 °C und 500 °C formbar sind, ggf. durch Anwendung eines Drucks, und welche nicht unterhalb von 200 °C schmelzen. Es ist jedoch nicht erforderlich, daß diese Polyimide überhaupt einen definierten Schmelzpunkt oder -bereich aufweisen. Es genügt, wenn sie, ohne zu schmelzen, einer Formgebung im angegebenen Temperaturbereich zugänglich sind.

Beispiele für geeignete heißsiegelbare Polyimide bzw. deren Vorstufen, die Polyamidsäuren, sind in der europäischen Patentanmeldeschrift 167 020 genannt. Die entsprechenden Ausführungen dieser Schrift werden zum Inhalt der vorliegenden Anmeldung gemacht.

Als Beispiele für heißsiegelbare Polyimide sind dort unter anderem solche genannt, die durch Umsetzung von Benzophenontetracarbonsäuredianhydrid (BTDA) oder einem Gemisch dieses Dianhydrids und Pyromellitsäuredianhydrid mit 4,4′-Diaminodiphenyläther, 4,4′-Diaminodiphenylsulfon (DDS) oder 4,4′-Diaminodiphenylmethan (DDM) oder mit Gemischen dieser Diamine erhalten werden. Es können hierbei Gemische eingesetzt werden, die zwei oder alle drei der genannten Diamine enthalten. Das Benzophenontetracarbonsäuredianhydrid kann das 2,3, 2′,3′- oder das 3,4, 3′,4′- oder das 2,3, 3′,4′-Isomere oder ein Gemisch aus diesen Isomeren sein.

Ferner können als Diamine hierbei 3,3′- oder 3,4′-Diaminodiphenyläther oder 3,3′-Diaminodiphenylsulfon oder 2,2-Bis-(p-Aminophenoxyphenyl)-propan oder Gemische dieser Amine eingesetzt werden. Die letztgenannte Verbindung, die ein Bisphenol A darstellt, dessen Hydroxylwasserstoffe jeweils durch den p-Aminophenyl-Rest substituiert sind, hat sich als besonders vorteilhaft erwiesen.

Weitere Beispiele für gut geeignete heißsiegelbare Polyimide sind Polyätherimide, wie sie z. B. in der europäischen Patentanmeldung Nr. 133 533 genannt sind. Polyätherimide enthalten neben Imidgruppierungen noch zusätzlich mehrere Ätherbindungen im Molekül. Eine bevorzugte Ausführungsform des erfindungsgemäßen Verfahrens besteht darin, daß man eine Polyamidsäurelösung, aus der sich ein Polyätherimid erhalten läßt, oder eine Lösung eines Polyätherimids verwendet.

In einer anderen bevorzugten Ausführungsform führt man das Verfahren so durch, daß Laminate entstehen, in denen die Polyimidschicht aus einem nicht mehr formbaren, vollaromatischen Polyimid besteht. Diese Ausführungsform ist deshalb häufig bevorzugt, weil für gewisse Anwendungszwecke der Metall/Polyimid-Laminate hohe Temperaturbeständigkeit gefordert wird und die vollaromatischen, nicht mehr formbaren Polyimide in ihren thermischen Eigenschaften, d. h. ihrer Beständigkeit bei hohen Temperaturen, den heißsiegelbaren Polyimiden überlegen sind. Unter « nicht mehr formbar » wird in diesem Zusammenhang verstanden, daß diese Polyimide nicht unterhalb von etwa 500 °C schmelzen oder erweichen, so daß unterhalb von etwa 500 °C keine Formgebung der Polyimide im festen Aggregatszustand möglich ist. Nicht mehr formbare Polyimide lassen sich ebenso wie heißsiegelbare Polyimide aus Polyamidsäuren durch Hitzebehandlung herstellen. Ob bei der Umwandlung einer Polyamidsäure in Polyimid ein heißsiegelbares oder ein nicht mehr formbares Polyimid entsteht, ist jedoch nicht allein von der chemischen Natur der Polyamidsäure bzw. der zur Polyamidsäure führenden Vorprodukte abhängig, sondern auch von den Verfahrensbedingungen. Polyamidsäuren werden zweckmäßig durch Umsetzung von Tetracarbonsäuren oder deren Dianhydriden mit Diaminen hergestellt. Je nach chemischer Struktur der Dianhydride, der Diamine, dem Mengenverhältnis beider und der Temperaturführung bei der Umwandlung der Polyamidsäure in Polyimid können heißsiegelbare oder nicht mehr formbare Polyimid erhalten werden. Selbst aus identischen Vorprodukten lassen sich also durch Variation des Mengenverhältnisses und/oder der Temperaturführung beide Klassen von Polyimiden herstellen.

Unter « vollaromatischen Polyimiden » werden hierbei Polyimide verstanden, die aus aromatischen Tetracarbonsäuren bzw. deren Dianhydriden oder Estern oder Teilestern und aus primären aromatischen Diaminen über die Zwischenstufe der Poliamidsäuren erhalten werden, wobei die Carboxyl- bzw. die primären Aminogruppen direkt an einen aromatischen Ring gebunden sind.

Für den Fall, daß mit dem erfindungsgemäßen Verfahren Laminate hergestellt werden sollen, welche ein nicht mehr formbares vollaromatisches Polyimid enthalten, ist es zweckmäßig und in einer Reihe von Fällen wegen schlechter Löslichkeit oder wegen Unlöslichkeit dieser Polyimide sogar unerläßlich, den Träger nicht mit einer Lösung des Polyimids selbst zu beschichten, sondern mit einer Lösung der entsprechenden Polyamidsäure. Eine bevorzugte Ausführungsform des Verfahrens besteht hierbei darin, daß man eine Polyamidsäure einsetzt, die sich aus Pyromellitsäuredianhydrid und 4,4′-Diaminodiphenyläther erhalten läßt.

Nicht mehr formbare Polyimide können auch aus anderen Polyamidsäuren bzw. deren Vorprodukten,

nämlich Dianhydriden bzw. Tetracarbonsäuren und Diaminen, erhalten werden. Beispiele geeigneter Dianhydride sind 2,3,6,7-Naphthalintetracarbonsäuredianhydrid, 3,4,3',4'-Diphenylsulfontetracarbonsäuredianhydrid, Perylen-3,4,9,10-tetracarbonsäuredianhydrid, 3,4,3',4'-Diphenyläther-tetracarbonsäuredianhydrid.

Beispiele für Diamine, die mit den Tetracarbonsäuren bzw. deren Derivaten zu geeigneten nicht mehr formbaren, vollaromatischen Polyimiden umgesetzt werden können, sind: 4,4'-Diaminodiphenyläther; 5-Amino-2(p-Aminophenyl)-Benzothiazol; 4-Amino-2-(p-Aminophenyl)-Benzothiazol: 5-Amino-2-(m-Aminophenyl)-Benzothiazol; 5-Amino-2-(p-Aminophenyl)-Benzoxazol; 4-Amino-2-(m-Aminophenyl)-Benzothiazol; p- und m-Phenylendiamin; 4,4'-Diamino-Diphenyl; Bis-(4-Aminophenyl)-Methan; 4-Amino-2-(p-Aminophenyl)-Benzoxazol; 4-Amino-2-(m-aminophenyl)-benzoxazol; 5-Amino-2-(m-Aminophenyl)-Benzoxazol: 2,5-Diamino-Benzoxazol: 2,5-Diamino-Benzothiazol.

Bei dem erfindungsgemäßen Verfahren wird auf den aus Metall M 1 und Material M 2 bestehenden Träger eine Lösung aufgebracht, und zwar auf die freiliegende, d. h. die nicht mit M 2 verbundene, Oberfläche des Metalls M 1. Die Lösung kann entweder bereits das Polyimid gelöst enthalten, das als Bestandteil des herzustellenden Laminats vorgesehen ist, oder die Lösung einer Polyamidsäure sein, die in ein Polyimid, z. B. durch Hitzebehandlung, umgewandelt werden kann. Für den Fall, daß das entstehende Polyimid nicht mehr formbar und vollaromatisch sein soll, ist die letztere Ausführungsform zweckmäßig. Geeignete Lösungsmittel sind hierbei z. B. N,N-Dimethylacetamid, N,N-Dimethylmethoxyacetamid, Dimethylformamid, Diäthylformamid, N-Methyl-2-pyrrolidon und Dimethylsulfoxid. Die Konzentration der Lösung an Polyimid bzw. Polyamidsäure kann in relativ weiten Grenzen variiert werden. Zweckmäßigerweise beträgt sie etwa 10 bis 35 Gew.-%.

Das Aufbringen der Lösung auf den Träger kann nach verschiedenen Methoden erfolgen. Vorteilhaft ist eine Applikation mittels Extrudieren, vor allem wenn das Verfahren kontinuierlich durchgeführt wird. Alternativ kann die Lösung auch aufgerakelt werden. Eine bevorzugte Ausführungsform des erfindungsgemäßen Verfahrens besteht darin, daß man eine Polyamidsäurelösung, die aus einer aromatischen Tetracarbonsäure oder deren Dianhydrid und einem primären aromatischen Diamin gebildet wird, auf den Träger ohne Zwischenschicht aufbringt und den beschichteten Träger erhitzt, wobei man die aromatische Tetracarbonsäure oder deren Dianhydrid mit einem aromatischen Diamin im Molverhältnis von 0,95 : 1 bis 1,05 : 1 in einem polaren organischen Lösungsmittel zu einer Polymerverbindung aus einer Polyamidsäure mit der Formel

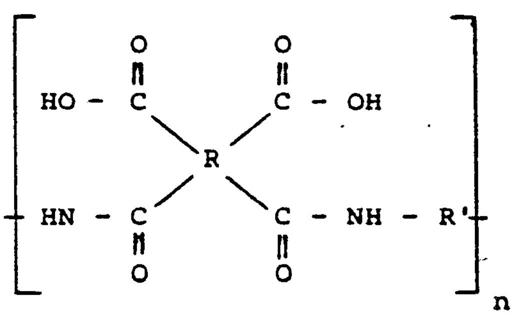

wobei

R einen aromatischen vierwertigen Rest und

R' einen zweiwertigen aromatischen Rest darstellen und

n ausreicht, um eine Polyamidsäure mit einem $\eta_{red}$-Wert von mindestens 0,5 zu erhalten, umgesetzt hat, aus der erhaltenen Polyamidsäurelösung auf dem Träger das Lösungsmittel in einer ersten Stufe, deren Temperatur im Bereich von 100 bis 200 °C liegt, in situ entfernt, wobei im wesentlichen die gesamte Lösungsmittelmenge entfernt wird, und den Film in einer zweiten Stufe, bei der die Temperatur mehr als 200 °C, vorzugsweise mehr als 300 °C beträgt, in situ zu einem Polyimid aushärtet, wobei mindestens 95 % der Polyamidsäure zu Polyimid umgesetzt werden, und daß man anschließend das Material M 2 entfernt. Die oben genannte Größe $\eta$red stellt die reduzierte Viskosität dar, gemessen an einer 0,5 Gew.-%igen Lösung der Polyamidsäure in Dimethylacetamid, das 0,1 Mol/l Lithiumbromid enthält.

In einer bevorzugten Ausführungsform wird dabei der Film in situ zu einem nicht mehr formbaren Polyimid ausgehärtet.

Für diesen letzteren Fall ist die Durchführung dieser Verfahrensschritte mit Ausnahme der Entfernung des Materials M 2 in der DE-OS 33 01 197 beschrieben. Die entsprechenden Ausführungen dieser Schrift werden zum Inhalt der vorliegenden Anmeldung gemacht. In dieser Schrift finden sich ferner Angaben bezüglich einer geeigneten Vorrichtung.

Nach dem Aufbringen der Lösung des Polyimids oder der Polyamidsäure auf den Träger wird die Lösung in festes Polyimid umgewandelt. Dies kann, wenn die Lösung einer Polyamidsäure verwendet wurde, nach dem oben beschriebenen Verfahren geschehen oder mittels einer anderen Hitzebehandlung unter Bedingungen, welche die Umwandlung der Polyamidsäure in festes Polyimid gewährleisten. Die Durchführung solcher Hitzebehandlungen ist aus der Literatur bekannt. Wenn die Lösung des fertig

vorgebildeten Polyimids eingesetzt wurde, muß dagegen lediglich das Lösungsmittel entfernt werden. Dies kann wie im Fall der Verwendung von Polyamidsäurelösungen durch eine Hitzebehandlung geschehen. Wenn ein niedrigsiedendes Lösungsmittel für das Polyimid verwendet wurde, kann in diesem Fall auch so verfahren werden, daß man das Lösungsmittel bei Raumtemperatur verdunsten läßt. Gegebenenfalls kann die Entfernung des Lösungsmittels unter vermindertem Druck durchgeführt werden.

Anschließend an die Umwandlung der Lösung in festes Polyimid muß das Material M 2 entfernt werden, Dies geschieht wie bereits erwähnt, in einer bevorzugten Ausführungsform dadurch, daß man das Material M 2 als Ganzes mechanisch durch Abziehen entfernt. Erleichtert wird diese Methode durch niedrige Schälfestigkeiten zwischen Metall M 1 und Material M 2 und indem man M 2 ggf. als Folie einsetzt.

Das erfindungsgemäße Verfahren wird vorzugsweise vollständig oder zum überwiegenden Teil kontinuierlich durchgeführt. Ein voll kontinuierliches Verfahren kann hierbei darin bestehen, auf den aus M 1 und M 2 bestehenden Träger eine Lösung eines Polyimids oder einer Polyamidsäure aufzubringen, den so beschichteten Träger kontinuierlich durch eine oder mehrere Heizzonen zu führen und anschließend das Material M 2 kontinuierlich zu entfernen. Der zu beschichtende Träger wird hierbei kontinuierlich, zum Beispiel in Form einer Länge einer Folie, zugeliefert und kontinuierlich beschichtet, zum Beispiel durch Extrudieren der entsprechenden Lösung auf den Träger. Die kontinuierliche Entfernung des Materials M 2 ist möglich, wenn dessen Haftfestigkeit an Metall M 1 niedrig ist. Sie kann beispielsweise so erfolgen, daß bei Beginn des Verfahrens von dem die Heizzone(n) verlassenden beschichteten Träger mechanisch eine kurze Länge, zum Beispiel einige cm, der Schicht aus Material M 2 abgezogen werden, worauf die abgetrennte Schicht aus M 2 einerseits und das Laminat aus Polyimid und Metall M 1 andererseits auf zwei verschiedene rotierende Abzugswalzen gelegt werden. Bei etwas höherer Haftung zwischen Metall M 1 und Material M 2 kann es zweckmäßig sein, nur das Beschichten des Trägers mit Lösung und das nachfolgende Umwandeln der Lösung in Polyimid kontinuierlich durchzuführen und die Entfernung der Schicht aus Material M 2 diskontinuierlich anzuschließen.

Die nach dem erfindungsgemäßen Verfahren erhaltenen Laminate, welche eine Schicht aus Metall M 1 und eine direkt damit verbundene Schicht aus Polyimid aufweisen, können als solche verwendet werden. Vorteilhafte Möglichkeiten sind die Verwendung in gedruckten Schaltkreisen, für planare Sicherungen, Widerstandsfolien für Dünnfilm-Kondensatoren oder als Abschirmfolien, z. B. für Hochfrequenzabschirmung. Die Laminate können vorteilhaft auch als Masken zur teilweisen Abdeckung von Substraten bei deren Bestrahlung mit elektromagnetischen Wellen eingesetzt werden. Weitere Anwendungsmöglichkeiten sind elektrische und magnetische Schalter, Heizleiter, Materialien für magnetische Informationsspeicherung, Reflexionsfolien, Permeationsbarrieren oder Solarkontrollfilme.

Es können auf eine oder beide freiliegende(n) Seite(n) der Laminate auch weitere Schichten aus Metall und/oder Polyimid aufgebracht werden. Wenn das Polyimid in dem hergestellten Laminat ein heißsiegelbares Polyimid ist, kann z. B. auf diese Polyimidschicht eine weitere Metallschicht unter Einwirkung von Druck und Hitze aufgebracht werden oder auch ein Laminat, das aus einer Metallschicht und aus einer Schicht aus nicht mehr formbarem Polyimid besteht. In letzterem Fall kann man demnach ein Mehrschicht-Laminat mit der Schichtenfolge :

Metall (M 1)/heißsiegelbares Polyimid/nicht mehr formbares Polyimid/Metall erhalten.

Solche Laminate eignen sich ebenfalls für den Einsatz in gedruckten Schaltkreisen.

Es ist auch möglich, das Verfahren so durchzuführen, daß eine Polyamidsäurelösung verwendet wird, die zu einem nicht mehr formbaren Polyimid führt und daß vor, während oder nach der Umwandlung der Lösung in festes Polyimid auf die Schicht aus Polyamidsäure bzw. auf die Schicht aus nicht mehr formbarem Polyamid eine Schicht aus einer Lösung eines heißsiegelbaren Polyimids oder eine Folie aus einem heißsiegelbaren Polyimid aufgebracht wird und daß anschließend die Umwandlung der Lösung bzw. Lösungen in festes Polyimid durchgeführt wird.

In diesen Fällen entstehen Laminate mit der Schichtenfolge : Metall M 1/nicht mehr formbares Polyimid/heißsiegelbares Polyimid. Auf die Schicht aus heißsiegelbarem Polyimid dieser Laminate können weitere Schichten aufgebracht werden, z. B. Laminate, welche aus einem Metall M 1 und Polyimid bestehen und ebenfalls nach dem erfindungsgemäßen Verfahren hergestellt worden sind. Die Verbindung dieser beiden Laminate wird über das heißsiegelbare Polyimid unter Anwendung erhöhter Temperatur sowie gegebenenfalls zusätzlich unter Druck bewirkt. Die Maßnahme, die Lösung bzw. Folie aus heißsiegelbarem Polyimid noch vor oder während der Umwandlung der Polyamidsäurelösung in nicht mehr formbares Polyimid aufzubringen, ist häufig vorteilhaft und dient dem Zweck, die Haftung zwischen nicht mehr formbarem und heißsiegelbarem Polyimid zu erhöhen. Es kann hierbei zweckmäßig sein, die Lösung bzw. Folie erst aufzubringen, wenn bereits ein erheblicher Teil des Lösungsmittels der Polyamidsäurelösung entfernt worden ist. Anschließend kann ein Laminat, bestehend aus einer Metallschicht und einer oder mehreren damit verbundenen Polyimidschicht(en), aufgebracht werden.

Das Aufbringen weiterer Schicht(en) auf die Schicht aus heißsiegelbarem Polyimid erfolgt nach Umwandlung der Lösung, die auf Metall M 1 aufgebracht wurde, in festes Polyimid. Wenn zur Ausbildung der Schicht aus heißsiegelbarem Polyimid nicht eine Folie, sondern eine Lösung dieses Polyimids aufgebracht wurde, wird auch diese in festes Polyimid umgewandelt, bevor weitere Schichten aufgebracht werden. Das Verbinden der zusätzlich aufgebrachten Schichten mit der Schicht aus heißsiegelbarem Polyimid erfolgt bei erhöhter Temperatur, nämlich einer Temperatur, bei der das heißsiegelbare Polyimid formbar ist. Gegebenenfalls kann zusätzlich unter Druck gearbeitet werden. In einer bevorzugten Ausführungsform bestehen die zusätzlich aufgebrachten Schichten aus einem Laminat aus einer Metallschicht und einer damit verbundenen Polyimidschicht, z. B. einem Laminat, das nach dem erfindungsgemäßen Verfahren hergestellt wurde. Auf diese Weise kann man zu Mehrschichtlaminaten, sogenannten double-clads oder multi-clads mit niedriger Gesamtschichtdicke gelangen.

Auch auf die Schicht aus Metall (M 1) der erfindungsgemäßen Laminate können eine oder mehrere weitere Schichten aufgebracht werden, wobei zweckmäßigerweise die auf das Metall M 1 zu liegen kommende Schicht eine Schicht aus Polyimid ist. Dies kann zum Beispiel geschehen, indem man in einem ersten Schritt die freiliegende Oberfläche von M 1 mit der Lösung einer Polyamidsäure beschichtet und diese zu einem heißsiegelbaren Polyamid aushärtet und anschließend auf diese Schicht aus heißsiegelbarem Polyamid wieder eine Metallschicht aufbringt.

Die Erfindung wird nunmehr durch Ausführungsbeispiele veranschaulicht.

## Beispiel 1

Eine Aluminiumfolie mit einer Schichtdicke von 25 μm wurde mit Kupfer beschichtet. Das Aufbringen der Schicht aus Kupfer erfolgte durch thermisches Aufdampfen, so daß das Cu die Al-Oberfläche vollständig bedeckte. Die Dicke der Cu-Schicht betrug 0,1 μm. Der erhaltene Träger wurde mit einer 25 Gew.-%igen Lösung einer Polyamidsäure in N-Methylpyrrolidon (NMP) beschichtet, wobei die Polyamidsäurelösung auf die freiliegende Cu-Oberfläche extrudiert wurde. Die Polyamidsäure wurde aus Pyromellitsäuredianhydrid (PMDA) und 4,4'-Diaminodiphenyläther (DADE) in Anlehnung an die in der DE-OS 33 01 197 in Beispiel 1 angegebene Methode erhalten. Die Umwandlung der Polyamidsäure in festes Polyimid erfolgte ebenfalls wie in Beispiel 1 der o.a. DE-OS angegeben. Es wurde eine 66 μm dicke Polyimidschicht erhalten. Anschließend wurde die Aluminiumfolie, die am Kupfer mit einer Schälfestigkeit von etwa 0,05 N/cm haftete, mechanisch als Ganzes abgezogen. Es resultierte ein Laminat mit sehr guter Haftung des Kupfers am Polyimid.

## Beispiel 2

Eine Al-Folie wie in Beispiel 1 wurde mit einer 4 Gew.-%igen wäßrigen Natriumsilikatlösung beschichtet. Nach Trocknung wurde Kupfer auf die Silikatoberfläche durch eine Maske hindurch in Form einer Leiterbahnstruktur aufgedampft, so daß eine Oberfläche aus Silikat erhalten wurde, auf der sich Leiterbahnen aus 0,2 μm dicker Kupferschicht befanden.

Anschließend wurde auf die aus Silikat und Cu bestehende Oberfläche eine Lösung einer Polyamidsäure, gebildet aus PMDA/DADE, aufgebracht wie in Beispiel 1 angegeben mit der Abweichung, daß eine Menge aufgebracht wurde, die zu einer 10 μm dicken Polyimidschicht führte. Im Anschluß daran wurde, noch vor der Umwandlung dieser Lösung in festes Polyimid, eine Lösung eines heißsiegelbaren Polyimids aufgebracht. Anschließend wurden durch Hitzebehandlung die beiden Lösungen in die entsprechenden Polyimide umgewandelt. Das hierzu verwendete heißsiegelbare Polyimid war ein Polyätherimid folgender Struktur

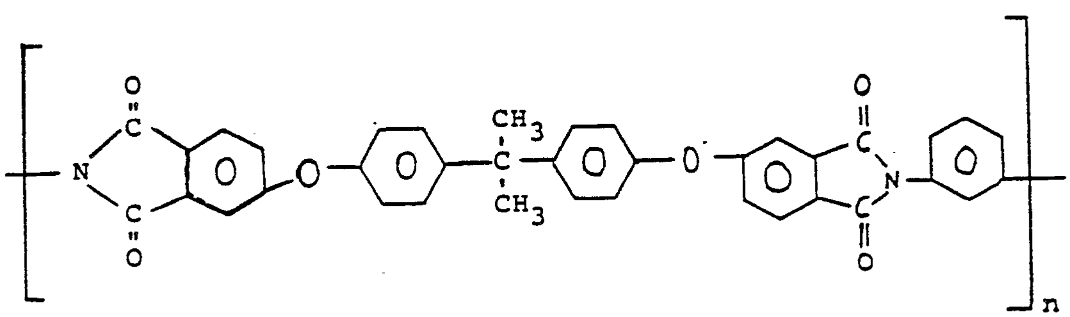

Die Schichtdicke des heißsiegelbaren Polyimids wurde durch die Menge und Konzentration der aufgebrachten Lösung vorgegeben und betrug 2 μm.

Von dem erhaltenen Laminat wurde anschließend die Al-Folie zusammen mit Silikat abgezogen. Anschließend wurde auf diejenige Oberfläche, auf der sich das Cu befand, ein Laminat aufgebracht, das aus einer Schicht aus nicht mehr formbarem PMDA/DADE-Polyimid und einer damit verbundenen Schicht aus heißsiegelbarem Polyimid bestand. Das heißsiegelbare Polyimid war das gleiche wie in diesem Beispiel oben angegeben. Das Aufbringen des Laminats geschah so, daß die Schicht aus heißsiegelbarem Polyimid auf die Cu-Oberfläche zu liegen kam.

Die Hießversiegelung erfolgte bei 300 °C und 30 bar. Es wurde ein Mehrfach-Laminat mit ausgezeichneter Haftung der einzelnen Schichten zueinander erhalten.

Beispiel 3

Auf eine 35 µm dicke Kupferfolie wurde eine 0,5 µm dicke Aluminiumschicht aufgedampft. Die Schälfestigkeit zwischen Cu und Al betrug weniger als 0,05 N/cm. Anschließend wurde eine aus PMDA/DADE erhaltene Polyamidsäurelösung in Dimethylacetamid durch Extrudieren auf die Al-Oberfläche aufgebracht. Die Umwandlung in festes Polyimid erfolgte wie im Fall von Beispiel 1. Anschließend wurde die Cu-Folie als Ganzes mechanisch abgezogen. Erhalten wurde ein Laminat mit einer gut an Polyimid haftender, 0,5 µm dicker Al-Schicht.

Beispiel 4

Auf eine 35 µm dicke Kupferfolie wurde eine 2 µm dicke Al-Schicht aufgesprüht, wobei unter vermindertem Druck gearbeitet wurde. Auf der Al-Schicht wurde gemäß den obigen Angaben eine 20 µm dicke Polyimidschicht, gebildet ausgehend von PMDA/DADE, erzeugt. Anschließend wurde die Cu-Folie abgezogen. Erhalten wurde ein Laminat aus einer 20 µm dicken Polyimidschicht und einer 2 µm dicken Al-Schicht, die gut aneinander hafteten.

Beispiel 5

Auf eine 25 µm dicke Edelstahlfolie wurde eine 0,2 µm dicke Schicht aus Aluminium durch Sprühen aufgebracht. Nach Aufbringen einer DMAc-Lösung einer Polyamidsäure, die aus PMDA/DADE erhalten worden war, auf die Aluminiumoberfläche wurde nach der in Beispiel 1 angegebenen Methode die Lösung in festes Polyimid einer Schichtdicke von 35 µm umgewandelt. Von dem erhaltenen Laminat ließ sich die Edelstahlfolie leicht abziehen. Es wurde ein Laminat aus einer 35 µm dicken Polyimidschicht und einer 0,2 µm dicken Al-Schicht erhalten, die gut aneinander hafteten.

Die Bezeichnung DMAc steht für N,N-Dimethylacetamid.

Beispiel 6

Es wurde wie in Beispiel 4 gearbeitet mit dem Unterschied, daß als Ausgangsmaterial für das Polyimid eine Lösung einer Polyamidsäure verwendet wurde, die aus 3,4, 3'4'-Benzophenontetracarbonsäure-dianhydrid und DADE erhalten wurde. Nach Entfernung der Kupferfolie wurde ein Laminat mit guter Haftung zwischen Al und Polyimid erhalten. Die Dicke der Polyimidschicht betrug wie in Beispiel 4 20 µm.

Beispiel 7

Es wurde wie in Beispiel 3 gearbeitet mit dem Unterschied, daß die Aluminiumschicht 0,2 µm dick war und daß die Polyimidschicht aus einer Lösung einer Polyamidsäure erhalten wurde, die aus Benzophenontetracarbonsäuredianhydrid und 4,4'-Diaminodiphenylsulfon gebildet wurde. Nach der Umwandlung der Polyamidsäure in Polyimid und Entfernung der Cu-Schicht wurde ein Laminat aus einer 0,2 µm dicken Al-Schicht und einer 10 µm dicken Polyimidschicht mit guter Haftung der Schichten aneinander erhalten.

Beispiele 8a und 8b

Diese Beispiele demonstrieren die Eignung des erfingungsgemäßen Verfahrens zur Herstellung von Laminaten mit sehr niedriger Gesamtdicke.

Es wurde wie in Beispiel 3 gearbeitet mit der Abweichung, daß die Dicke der Al-Schicht 0,1 µm betrug. Die Schichtdicke des aus PMDA/DADE gebildeten Polyimids betrug 2 µm (Beispiel 8a) bzw. 4 µm (Beispiel 8b). Die Haftung zwischen der Al-Schicht und der Polyimidschicht war in beiden Fällen gut.

Beispiel 9

In diesem Beispiel wurde für Material M 2 ein nichtmetallisches Material verwendet.

Auf eine 50 µm dicke Folie aus PMDA/DADE-Polyimid (= Material M 2) wurde Al aufgedampft, so daß ein Träger mit einer 0,2 µm dicken Al-Schicht erhalten wurde. Auf die Metalloberfläche dieses Trägers wurde, wie in Beispiel 3 angegeben, die Lösung einer Polyamidsäure (PMDA/DADE) aufgebracht und zu einer 35 µm dicken Schicht aus Polyimid ausgehärtet. Obwohl in dem erhaltenen Produkt sich auf den beiden Oberflächen der Aluminiumschicht Schichten aus Polyimiden befanden, die aus den gleichen Ausgangsmaterialien (PMDA/DADE) hergestellt waren, gelang die Entfernung der 50 µm dicken Polyimidschicht auf mechanischem Wege, ohne daß die Haftung zwischen Al und der 35 µm dicken Polyimidschicht beeinträchtigt wurde. Es wird angenommen, daß die Ursache hierfür darin zu suchen ist, daß in einem Fall eine voll ausgehärtete Polyimidfolie vorlag, im anderen die Aushärtung zum Polyimid erst nach Aufbringen der Lösung auf die Al-Oberfläche vorgenommen wurde.

Beispiel 10

Wie in Beispiel 3 wurde auf Cu eine Al-Schicht aufgedampft, deren Dicke jedoch nur 0,1 µm betrug. Anschließend wurde eine Polyamidsäurelösung wie in Beispiel 3 aufgebracht und zwar in einer Menge, die zu einer 7 µm dicken Polyimidschicht führte. Vor der Umwandlung dieser Lösung in festes Polyimid wurde auf die Lösung der Polyamidsäure eine Lösung eines heißsiegelbaren Polyimids gemäß Beispiel 2 aufgebracht. Anschließend wurden, wie in Beispiel 3 angegeben, die Lösungen zu den entsprechenden Polyimiden ausgehärtet und die Kupferfolie (Material M 2) mechanisch abgezogen. Erhalten wurde ein Laminat mit der Schichtfolge 0,1 µm Al/0,7 µm PMDA-DADE-Polyimid/2 µm heißsiegelbares Polyimid. Dieses Laminat wurde durch Aufbringen weiterer Schichten zu einem Vierfachlaminat der Schichtenfolge Al/PI/PEI/Al/PI/PEI/Al/PI/PEI/Al/PI/PEI weiterverarbeitet. Hierbei bedeutet PI das PMDA/DADE-Polyimid (nicht mehr formbares Polyimid) und PEI das in Beispiel 2 genannte Polyätherimid (heißsiegelbares Polyimid). Das Vierfachlaminat wies gute Haftungseigenschaften zwischen benachbarten Schichten auf.

## Patentansprüche

1. Verfahren zur Herstellung von Laminaten aus mindestens einer Schicht aus einem Metall M 1 und mindestens einer direkt damit verbundenen Schicht aus Polyimid durch Aufbringen einer Schicht einer Lösung eines Polyimids oder einer Lösung einer in ein Polyimid umwandelbaren Polyamidsäure auf einen Träger und Umwandlung der Lösung in festes Polyimid, dadurch gekennzeichnet, daß man einen Träger verwendet, der aus einer Schicht aus einem Metall M 1 und einer damit verbundenen Schicht aus einem von M 1 verschiedenen Material M 2 besteht, wobei das Material M 2 mindestens eine glatte Oberfläche aufweist, auf der sich die Schicht aus Metall M 1 befindet, die durch Bedampfen, Bedrucken, Aufrakeln oder Aufsprühen des Metalls M 1 in elementarer Form auf diese Oberfläche erzeugt worden ist, daß man die Lösung des Polyimids oder der Polyamidsäure auf die freiliegende Oberfläche der Schicht aus Metall M 1 aufbringt und daß man nach der Umwandlung der Lösung in festes Polyimid die Schicht aus Material M 2 entfernt.

2. Verfahren nach Anspruch 1, dadurch gekennzeichnet, daß man als Material M 2 ein metallisches Material einsetzt.

3. Verfahren nach Anspruch 1, dadurch gekennzeichnet, daß man als Material M 2 einen, aus einem organischen Polymeren bestehenden Kunststoff verwendet, auf den das Metall M 1 so aufgebracht worden ist, daß es nicht die gesamte Oberfläche von M 2 bedeckt.

4. Verfahren nach einem oder mehreren der Ansprüche 1 bis 3, dadurch gekennzeichnet, daß man das Material M 2 in Form einer Folie verwendet.

5. Verfahren nach einem oder mehreren der Ansprüche 1 bis 4, dadurch gekennzeichnet, daß man einen Träger verwendet, bei dem die Schälfestigkeit, mit der die Schicht aus Metall M 1 am Material M 2 haftet, kleiner ist als etwa 2 N/cm.

6. Verfahren nach Anspruch 5, dadurch gekennzeichnet, daß die Schälfestigkeit kleiner ist als 0,5 N/cm.

7. Verfahren nach einem oder mehreren der Ansprüche 1 bis 6, dadurch gekennzeichnet, daß das Material M 2 aus einer Schicht aus Metall und einer damit verbundenen Schicht aus einem Oxid des Siliciums oder aus einem Metallsilikat besteht und daß die Schicht aus Metall M 1 auf die Schicht aus dem Oxid des Siliciums oder dem Metallsilikat aufgebracht worden ist.

8. Verfahren nach einem oder mehreren der Ansprüche 1 bis 7, dadurch gekennzeichnet, daß man das Material M 2 als Ganzes mechanisch durch Abziehen entfernt.

9. Verfahren nach einem oder mehreren der Ansprüche 1 bis 8, dadurch gekennzeichnet, daß man einen Träger verwendet, bei dem die Dicke der Schicht aus Metall M 1 einen Wert zwischen 0,05 µm und 4 µm besitzt.

10. Verfahren nach einem oder mehreren der Ansprüche 1 bis 9, dadurch gekennzeichnet, daß man einen Träger verwendet, bei dem die Dicke der Schicht aus Metall M 1 einen Wert zwischen 0,1 µm und 2 µm besitzt.

11. Verfahren nach einem oder mehreren der Ansprüche 1 bis 10, dadurch gekennzeichnet, daß man die Lösung des Polyimids oder der Polyamidsäure auf den Träger in einer Schichtdicke von 2 µm · x bis 75 µm · x aufbringt, wobei x der Quotient aus der Schichtdicke einer bestimmten Menge dieser Lösung und der Schichtdicke des aus dieser Menge zu erhaltenden festen Polyimids ist.

12. Verfahren nach einem oder mehreren der Ansprüche 1 bis 11, dadurch gekennzeichnet, daß man die Lösung des Polyimids oder der Polyamidsäure kontinuierlich auf einen kontinuierlich ablaufenden Träger aufbringt.

13. Verfahren nach einem oder mehreren der Ansprüche 2 bis 12, dadurch gekennzeichnet, daß als Material M 2 Kupfer, Nickel, Aluminium oder Edelstahl verwendet wird.

14. Verfahren nach einem oder mehreren der Ansprüche 1 bis 12, dadurch gekennzeichnet, daß als Material M 2 Silicium, Siliciumdioxid, Keramik oder Glas verwendet wird.

15. Verfahren nach einem oder mehreren der Ansprüche 1 bis 14, dadurch gekennzeichnet, daß als Metall M 1 Nickel, Kupfer, Aluminium, Chrom, Gold, Silber oder Palladium verwendet wird.

16. Verfahren nach einem oder mehreren der Ansprüche 1 bis 15, dadurch gekennzeichnet, daß man eine Polyamidsäurelösung, die aus einer aromatischen Tetracarbonsäure oder deren Dianhydrid und einem primären aromatischen Diamin gebildet wird, auf den Träger ohne Zwischenschicht aufbringt und den beschichteten Träger erhitzt, wobei man die aromatische Tetracarbonsäure oder deren Dianhydrid mit einem aromatischen Diamin im Molverhältnis von 0,95 : 1 bis 1,05 : 1 in einem polaren organischen Lösungsmittel zu einer Polymerverbindung aus einer Polyamidsäure mit der Formel

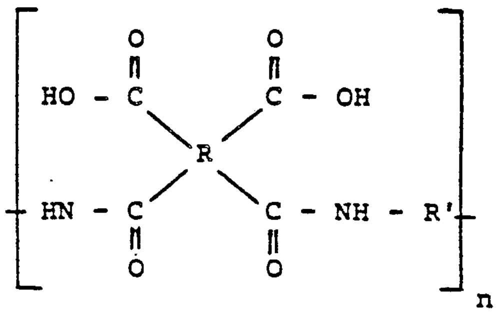

wobei

R einen aromatischen vierwertigen Rest und

R' einen zweiwertigen aromatischen Rest darstellen und

n ausreicht, um eine Polyamidsäure mit einem $\eta_{red}$-Wert von mindestens 0,5 zu erhalten, umgesetzt hat, aus der erhaltenen Polyamidsäurelösung auf dem Träger das Lösungsmittel in einer ersten Stufe, deren Temperatur im Bereich von 100 bis 200 °C liegt, in situ entfernt, wobei im wesentlichen die gesamte Lösungsmittelmenge entfernt wird, und den Film in einer zweiten Stufe, bei der die Temperatur mehr als 200 °C, vorzugsweise mehr als 300 °C beträgt, in situ zu einem Polyimid aushärtet, wobei mindestens 95 % der Polyamidsäure zu Polyimid umgesetzt werden, und daß man anschließend das Material M 2 entfernt.

17. Verfahren nach einem oder mehreren der Ansprüche 1 bis 16, dadurch gekennzeichnet, daß eine Lösung einer Polyamidsäure verwendet wird, die in ein nicht mehr formbares vollaromatisches Polyimid umgewandelt werden kann.

18. Verfahren nach Anspruch 16 oder Anspruch 17, dadurch gekennzeichnet, daß man den Film zu einem nicht mehr formbaren Polyimid aushärtet.

19. Verfahren nach einem oder mehreren der vorangehenden Ansprüche, dadurch gekennzeichnet, daß man eine Polyamidsäure verwendet, die sich aus Pyromellitsäuredianhydrid und 4,4'-Diaminodiphenyläther erhalten läßt.

20. Verfahren nach einem oder mehreren der Ansprüche 1 bis 16, dadurch gekennzeichnet, daß man eine Polyamidsäurelösung, aus der sich ein Polyätherimid erhalten läßt, oder eine Lösung eines Polyätherimids verwendet.

21. Verfahren nach einem oder mehreren der Ansprüche 1 bis 20, dadurch gekennzeichnet, daß auf die freiliegende Oberfläche der Polyimidschicht der erhaltenen Laminate eine oder mehrere weitere Schicht(en) aufgebracht wird bzw. werden, die aus der Gruppe der Polyimide und Metalle ausgewählt sind.

22. Verfahren nach einem oder mehreren der vorangehenden Ansprüche, dadurch gekennzeichnet, daß eine Polyamidsäurelösung verwendet wird, die zu einem nicht mehr formbaren Polyimid führt und daß vor oder während der Umwandlung der Lösung in festes Polyimid auf die Schicht aus Polyamidsäure eine Schicht aus einer Lösung eines heißsiegelbaren Polyimids oder eine Folie aus einem heißsiegelbaren Polyimid aufgebracht wird und daß anschließend die Umwandlung der Lösung bzw. Lösungen in festes Polyimid durchgeführt wird.

23. Verfahren nach Anspruch 22, dadurch gekennzeichnet, daß nach der Umwandlung der Lösung bzw. Lösungen in festes Polyimid auf die Schicht aus heißsiegelbarem Polyimid ein Laminat, bestehend aus einer Metallschicht und einer oder mehreren damit verbundenen Polyimidschicht(en) aufgebracht wird.

24. Verfahren nach einem oder mehreren der Ansprüche 1 bis 23, dadurch gekennzeichnet, daß auf die freiliegende Oberfläche der Schicht aus Metall M 1 der erhaltenen Laminate eine oder mehrere Schicht(en) aufgebracht wird bzw. werden, wobei die auf die Oberfläche aus Metall M 1 zu liegen kommende Schicht aus Polyimid besteht.

25. Verwendung der nach einem oder mehreren der Ansprüche 1 bis 24 hergestellten Laminate für Dünnfilmkondensatoren.

26. Verwendung der nach einem oder mehreren der Ansprüche 1 bis 24 hergestellten Laminate als Abschirmfolien.

27. Verwendung der nach einem oder mehreren der Ansprüche 1 bis 24 hergestellten Laminate für gedruckte Schaltkreise.

28. Verwendung der nach einem oder mehreren der Ansprüche 1 bis 24 hergestellten Laminate als planare Sicherungen.

29. Verwendung der nach einem oder mehreren der Ansprüche 1 bis 24 hergestellten Laminate als Widerstandsfolien.

30. Verwendung der nach einem oder mehreren der Ansprüche 1 bis 24 hergestellten Laminate als Masken zur teilweisen Abdeckung von Substraten bei der Bestrahlung mit elektromagnetischen Wellen.

**Claims**

1. Process for producing laminates from at least one layer consisting of a metal M 1 and at least one polyimide layer, directly bonded thereto, by applying a layer of a solution of a polyimide or of a solution of a polyamide-acid, convertible to a polyimide, to a carrier and converting the solution to solid polyimide, characterized in that a carrier is used which consists of a layer of a metal M 1 and a layer, bonded thereto, of a material M 2 different from M 1, the material M 2 having at least one smooth surface on which the layer of metal M 1 is located, which layer has been produced by vapour deposition, printing, knife application or spraying of the metal M 1 in the elemental form on this surface, that the solution of the polyimide or of the polyamide-acid is applied to the exposed surface of the layer of metal M 1, and that, after the conversion of the solution to solid polyimide, the layer of material M 2 is removed.

2. Process according to Claim 1, characterized in that a metallic material is used as the material M 2.

3. Process according to Claim 1, characterized in that a plastic which consists of an organic polymer and to which the metal M 1 has been applied in such a way that it does not cover the entire surface of M 2, is used as the material M 2.

4. Process according to one or more of Claims 1 to 3, characterized in that the material M 2 is used in the form of a film or foil.

5. Process according to one or more of Claims 1 to 4, characterized in that a carrier is used in which the peel strength, with which the layer of metal M 1 adheres to the material M 2, is less than about 2 N/cm.

6. Process according to Claim 5, characterized in that the peel strength is less than 0.5 N/cm.

7. Process according to one or more of Claims 1 to 6, characterized in that the material M 2 consists of a layer of metal and a layer, bonded thereto, of an oxide of silicon or of a metal silicate, and that the layer of metal M 1 has been applied to the layer of the oxide of silicon or the metal silicate.

8. Process according to one or more of Claims 1 to 7, characterized in that the material M 2 is removed mechanically as a whole by peeling off.

9. Process according to one or more of Claims 1 to 8, characterized in that a carrier in which the thickness of the layer of metal M 1 has a value of between 0.05 µm and 4 µm.

10. Process according to one or more of Claims 1 to 9, characterized in that a carrier is used in which the thickness of the layer of metal M 1 has a value of between 0.1 µm and 2 µm.

11. Process according to one or more of Claims 1 to 10, characterized in that the solution of the polyimide or of the polyamide-acid is applied to the carrier in a layer thickness from 2 µm × to 75 µm x, x being the quotient of the layer thickness of a defined quantity of this solution and the layer thickness of the solid polyimide to be obtained from this quantity.

12. Process according to one or more of Claims 1 to 11, characterized in that the solution of the polyimide or of the polyamide-acid is applied continuously to a continuously running carrier.

13. Process according to one or more of Claims 2 to 12, characterized in that copper, nickel, aluminium or stainless steel is used as the material M 2.

14. Process according to one or more of Claims 1 to 12, characterized in that silicon, silicon dioxide, a ceramic or glass is used as the material M 2.

15. Process according to one or more of Claims 1 to 14, characterized in that nickel, copper, aluminium, chromium, gold, silver or palladium is used as the metal M 1.

16. Process according to one or more of Claims 1 to 15, characterized in that a polyamide-acid solution, which is formed from an aromatic tetracarboxylic acid or the dianhydride thereof and a primary aromatic diamine is applied to the carrier without an interlayer and the coated carrier is heated, the aromatic tetracarboxylic acid or the dianhydride thereof having been reacted with an aromatic diamine in a molar ratio from 0.95 : 1 to 1.05 : 1 in a polar organic solvent to give a polymeric compound of a polyamide-acid of the formula

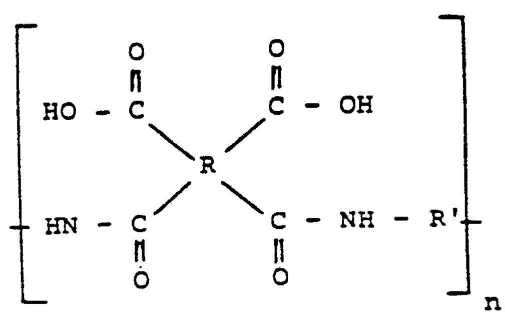

in which

R is an aromatic tetravalent radical and

R' is a divalent aromatic radical and

n is sufficient for obtaining a polyamide-acid having an $\eta_{red}$ value of at least 0.5, the solvent is removed in situ from the resulting polyamide-acid solution on the carrier in a first stage, the temperature of which is in the range from 100 to 200 °C, essentially the total quantity of solvent being removed, and the film is cured in situ to give a polyimide in a second stage, in which the temperature is more than 200 °C, preferably more than 300 °C, at least 95 % of the polyamide-acid being converted to polyimide, and that the material M 2 is subsequently removed.

17. Process according to one or more of Claims 1 to 16, characterized in that a solution of a polyamide-acid is used which can be converted to a fully aromatic polyimide which is no longer formable.

18. Process according to Claim 16 or 17, characterized in that the film is cured to give a polyimide which is no longer formable.

19. Process according to one or more of the preceding claims, characterized in that a polyamide-acid is used which is obtainable from pyromellitic dianhydride and 4,4'-diaminodiphenyl ether.

20. Process according to one or more of Claims 1 to 16, characterized in that a polyamide-acid solution, from which a polyether-imide is obtainable, or a solution of a polyether-imide is used.

21. Process according to one or more of Claims 1 to 20, characterized in that one or more further layer(s) selected from the group comprising the polyimides and metals is or are applied to the exposed surface of the polyimide layer of the resulting laminates.

22. Process according to one or more of the preceding claims, characterized in that a polyamide-acid solution is used which leads to a polyimide which is no longer formable, and that, before or during the conversion of the solution to solid polyimide, a layer of a solution of a heat-sealable polyimide or a film of a heat-sealable polyimide is applied to the layer of polyamide-acid and that the conversion of the solution or solutions to solid polyimide is carried out subsequently.

23. Process according to Claim 22, characterized in that, after the conversion of the solution or solutions to solid polyimide, a laminate consisting of a metal layer and one or more polyimide layer(s) bonded thereto is applied to the layer of heat sealable polyimide.

24. Process according to one or more of Claims 1 to 23, characterized in that one or more layer(s) is or are applied to the exposed surface of the layer of metal M 1 of the resulting laminates, the layer which comes to lie on the surface of metal M 1 consisting of polyimide.

25. Use of the laminates produced according to one or more of Claims 1 to 24 for thin-film capacitors.

26. Use of the laminates produced according to one or more of Claims 1 to 24 as screening foils.

27. Use of the laminates produced according to one or more of Claims 1 to 24 for printed circuits.

28. Use of the laminates produced according to one or more of Claims 1 to 24 as planar fuses.

29. Use of the laminates produced according to one or more of Claims 1 to 24 as resistance foils.

30. Use of the laminates produced according to one or more of Claims 1 to 24 as masks for partial screening of substrates in the irradiation with electromagnetic waves.

**Revendications**

1. Procédé de fabrication de stratifiés, constitués d'au moins une couche d'un métal M 1 et d'au moins une couche de polyimide, directement liée avec, par application, sur un support, d'une couche d'une solution d'un polyimide ou d'une solution d'un polyamide-acide transformable en un polyimide, et transformation de cette solution en un polyimide solide, caractérisé en ce que l'on utilise un support qui est constitué d'une couche d'un métal M 1 et d'une couche, liée avec, d'un matériau M 2 différent de M 1, le matériau M 2 présentant au moins une surface lisse sur laquelle se trouve la couche de métal M 1, qui a été formée sur cette surface par évaporation, impression, râclage ou pulvérisation du métal M 1 sous forme élémentaire, en ce que l'on dépose la solution du polyimide ou du polyamide-acide sur la surface libre de la couche de métal M 1 et en ce que l'on élimine la couche de matériau M 2 après la transformation de la solution en un polyimide solide.

2. Procédé conforme à la revendication 1, caractérisé en ce que l'on utilise comme matériau M 2 un matériau métallique.

3. Procédé conforme à la revendication 1, caractérisé en ce que l'on utilise comme matériau M 2 une matière plastique constituée d'un polymère organique, sur laquelle on a déposé le métal M 1 de telle façon que celui-ci ne recouvre pas la surface totale du matériau M 2.

4. Procédé selon une ou plusieurs des revendications 1 à 3, caractérisé en ce que l'on utilise le matériau M 2 sous forme d'une feuille.

5. Procédé selon une ou plusieurs des revendications 1 à 4, caractérisé en ce que l'on utilise un support dont la résistance à l'écaillage, force avec laquelle la couche de métal M 1 adhère au matériau M 2, est inférieure à environ 2 N/cm.

6. Procédé conforme à la revendication 5, caractérisé en ce que la résistance à l'écaillage est inférieure à 0,5 N/cm.

7. Procédé selon une ou plusieurs des revendications 1 à 6, caractérisé en ce que le matériau M 2 est

constitué d'une couche de métal et d'une couche, liée avec, d'un oxyde de silicium ou d'un silicate métallique, et en ce que la couche de métal M 1 a été déposée sur la couche d'oxyde de silicium ou de silicate métallique.

8. Procédé selon une ou plusieurs des revendications 1 à 7, caractérisé en ce que le matériau M 2 est éliminé en entier par voie mécanique, par pelage.

9. Procédé selon une ou plusieurs des revendications 1 à 8, caractérisé en ce que l'on utilise un support dont la couche de métal M 1 présente une épaisseur comprise entre 0,05 µm et 4 µm.

10. Procédé selon une ou plusieurs des revendications 1 à 9, caractérisé en ce que l'on utilise un support dont la couche de métal M 1 présente une épaisseur comprise entre 0,1 µm et 2 µm.

11. Procédé selon une ou plusieurs des revendications 1 à 10, caractérisé en ce que l'on dépose la solution du polyimide ou du polyamide-acide sur le support en une couche d'épaisseur 2 µm · x à 75 µm · x, x représentant le quotient de l'épaisseur de couche d'une certaine quantité de cette solution par l'épaisseur de couche du polyimide solide que l'on peut obtenir à partir de cette quantité.

12. Procédé selon une ou plusieurs des revendications 1 à 11, caractérisé en ce que l'on dépose en continu la solution du polyimide ou du polyamide-acide, sur un support en déplacement continu.

13. Procédé selon une ou plusieurs des revendications 2 à 12, caractérisé en ce que l'on utilise, en tant que matériau M 2, du cuivre, du nickel, de l'aluminium ou un acier spécial.

14. Procédé selon une ou plusieurs des revendications 1 à 12, caractérisé en ce que l'on utilise, en tant que matériau M 2, du silicium, du dioxyde de silicium, une céramique ou un verre.

15. Procédé selon une ou plusieurs des revendications 1 à 14, caractérisé en ce que l'on utilise, en tant que métal M 1, du nickel, du cuivre, de l'aluminium, du chrome, de l'or, de l'argent ou du palladium.

16. Procédé selon une ou plusieurs des revendications 1 à 15, caractérisé en ce que l'on dépose, sur le support et sans couche intermédiaire, une solution de polyamide-acide, formée à partir d'un acide aromatique tétracarboxylique ou de son dianhydride et d'une diamine primaire aromatique, et en ce que l'on chauffe le support revêtu, en ayant fait réagir l'acide aromatique tétracarboxylique ou son dianhydride avec une diamine aromatique en un rapport molaire de 0,95 : 1 à 1,05 : 1, dans un solvant polaire organique, pour obtenir un composé polymère constitué d'un polyamide-acide de formule :

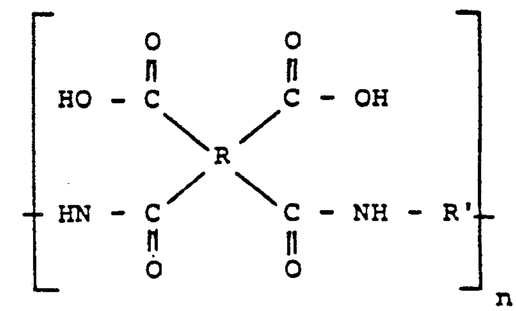

dans laquelle :

R représente un résidu aromatique tétravalent, et

R' représente un résidu aromatique divalent,

n ayant une valeur suffisante pour que l'on obtienne un polyamide-acide présentant une valeur de $\eta_{red}$ d'au moins 0,5, en ce que l'on élimine in situ, dans une première étape au cours de laquelle la température se situe dans la zone de 100 à 200 °C, le solvant de la solution de polyamide-acide obtenue sur le support, toute la quantité de solvant étant pratiquement éliminée au cours de cette étape, en ce que l'on fait durcir in situ le film en un polyimide, dans une deuxième étape au cours de laquelle on élève la température à plus de 200 °C et de préférence à plus de 300 °C, au moins 95 % du polyamide-acide étant transformé en polyimide, et en ce que pour finir, on élimine le matériau M 2.

17. Procédé selon une ou plusieurs des revendications 1 à 7, caractérisé en ce que l'on utilise une solution d'un polyamide-acide qui peut être transformée en un polyimide totalement aromatique qui n'est plus formable.

18. Procédé selon la revendication 16 ou la revendication 17, caractérisé en ce que l'on fait durcir le film en un polyimide qui n'est plus formable.

19. Procédé selon une ou plusieurs des revendications précédentes, caractérisé en ce que l'on utilise un polyamide-acide que l'on peut obtenir à partir du dianhydride de l'acide pyromellitique et du 4,4'-diaminodiphényléther.

20. Procédé selon une ou plusieurs des revendications 1 à 16, caractérisé en ce que l'on utilise une solution de polyamide-acide à partir de laquelle on peut obtenir un polyéther-imide, ou bien une solution d'un polyéther-imide.

21. Procédé selon une ou plusieurs des revendications 1 à 20, caractérisé en ce que l'on dépose, sur la surface libre de la couche de polyimide du stratifié obtenu, une ou plusieurs autres couches choisies dans le groupe des polyimides et des métaux.

22. Procédé selon une ou plusieurs des revendications précédentes, caractérisé en ce que l'on utilise

une solution de polyamide-acide conduisant à un polyimide qui n'est plus formable, en ce que l'on dépose, avant ou pendant la transformation de la solution en un polyimide solide, sur la couche de polyamide-acide, une couche d'une solution d'un polyimide thermo-soudable ou une feuille d'un polyimide thermo-soudable, et en ce que l'on effectue enfin la transformation de la solution ou des solutions en polyimide solide.

23. Procédé selon la revendication 22, caractérisé en ce que l'on dépose, après la transformation de la solution ou des solutions en polyimide solide, sur la couche de polyimide thermo-soudable, un stratifié constitué d'une couche métallique et d'une ou plusieurs couches de polyimide liées avec.

24. Procédé selon une ou plusieurs des revendications 1 à 23, caractérisé en ce que, sur la surface libre de la couche de métal M 1 du stratifié obtenu, on dépose une ou plusieurs couches, la couche venant en contact avec la surface de métal M 1 étant constituée de polyimide.

25. Utilisation des stratifiés fabriqués selon une ou plusieurs des revendications 1 à 24, pour des condensateurs à film mince.

26. Utilisation des stratifiés fabriqués selon une ou plusieurs des revendications 1 à 24, en tant que feuilles de protection.

27. Utilisation des stratifiés fabriqués selon une ou plusieurs des revendications 1 à 24, pour des circuits imprimés.

28. Utilisation des stratifiés fabriqués selon une ou plusieurs des revendications 1 à 24, en tant que fusibles plans.

29. Utilisation des stratifiés fabriqués selon une ou plusieurs des revendications 1 à 24, en tant que feuilles de résistance.

30. Utilisation des stratifiés fabriqués selon une ou plusieurs des revendications 1 à 24, en tant que masques pour le recouvrement partiel de substrats lors d'une irradiation avec des ondes électromagnétiques.